# EUROPÄISCHE PATENTSCHRIFT

(11) **EP 3 298 868 B1**
(45) Veröffentlichungstag und Bekanntmachung des Hinweises auf die Patenterteilung: **08.04.2020**
(21) Anmeldenummer: 16721812.2
(22) Anmeldetag: 11.05.2016
(51) Int. Cl.: H05K 9/00

(54) **ANORDNUNG ZUM SCHUTZ VON ELEKTRONIK GEGENÜBER STÖRSTRAHLUNG**
ARRANGEMENT FOR PROTECTING ELECTRONICS FROM INTERFERENCE RADIATION
DISPOSITIF POUR PROTÉGER L'ÉLECTRONIQUE CONTRE LE RAYONNEMENT PARASITE

(30) Priorität: 22.05.2015 DE 102015209468
(43) Veröffentlichungstag der Anmeldung: 28.03.2018
(73) Patentinhaber: Continental Teves AG & Co. OHG, 60488 Frankfurt am Main (DE); Conti Temic Microelectronic GmbH, 90411 Nürnberg (DE)
(72) Erfinder: GILB, Jürgen, 61273 Wehrheim (DE); JÜRGENS, Michael, 61200 Wölfersheim (DE); KREITMEYR, Erwin, 86558 Hohenwart/Koppenbach (DE); WEYRICH, Ralf, 55595 Weinsheim (DE)
(86) Internationale Anmeldenummer: PCT/EP2016/060521
(87) Internationale Veröffentlichungsnummer: WO 2016/188747

(56) Entgegenhaltungen:
- WO-A2-2012/113895
- US-A- 5 698 818
- US-A1- 2007 147 008

## Beschreibung

Die vorliegende Erfindung betrifft eine Anordnung zum Schutz von Elektronik gegenüber Störstrahlung gemäß Oberbegriff des Patentanspruchs 1.

Elektronische Geräte, welche unterschiedlichsten Umgebungsbedingungen ausgesetzt sind, werden zum Schutz der Elektronik häufig mit Druckausgleichsöffnungen versehen, welche beispielsweise Druckschwankungen in Folge unterschiedlicher Temperaturen innerhalb und außerhalb eines Gehäuses des betreffenden elektronischen Geräts und Kondensationsfeuchtigkeit reduzieren, welche sich negativ auf die Lebensdauer und Zuverlässigkeit der Elektronik sowie Dichtung des Gehäuses auswirken würden. In an sich bekannter Weise können zudem die Druckausgleichsöffnungen abdeckende Membranen vorgesehen sein, um ein Eindringen von Feuchtigkeit in das Gehäuse zu verhindern.

Häufig müssen elektronische Steuergeräte außerdem Anforderung an die elektromagnetische Verträglichkeit erfüllen, damit keine störenden Effekte, Beschädigungen oder Zerstörungen von Elektronikbauteilen stattfinden. Druckausgleichsöffnungen bilden aufgrund der Öffnungen des Gehäuses an dieser Stelle einen besonders anfälligen Bereich für das Eindringen elektrischer und/oder magnetischer Störstrahlung. In der WO 2012/113895 A2 ist ein Gehäuse beschrieben, welches zum Schutz einer elektrischen oder elektronischen Schaltung durch physikalische oder elektrostatische Schäden und zum Abzug von durch die elektrische oder elektronische Schaltung erzeugter Wärme eine Wand in einer Sandwich-Struktur aus zwei Deckplatten umfasst, die ineinandergreifende U-Profile unter Bildung von Entlüftungsöffnungen aufweisen. Dadurch können thermische Anforderungen und Anforderungen hinsichtlich elektromagnetischer Verträglichkeit, trotz vorhandener Öffnungen, erfüllt werden. Nachteilig bei dieser Lösung sind jedoch die Komplexität der Sandwich-Struktur und die damit verbundenen höheren Kosten bei der Herstellung.

Aufgabe der Erfindung ist es daher, eine alternative Anordnung zum Schutz von Elektronik gegenüber Störstrahlung bereitzustellen, welche möglichst kosteneffizient herstellbar sein soll.

Diese Aufgabe wird durch eine Anordnung gemäß Anspruch 1 gelöst.

Die Erfindung beschreibt eine Anordnung zum Schutz von Elektronik gegenüber Störstrahlung, umfassend ein Gehäuse und einen Schaltungsträger zum Aufnehmen der Elektronik in einem Inneren des Gehäuses, wobei das Gehäuse eine Öffnung zum Ausgleich unterschiedlicher Drücke innerhalb und außerhalb des Gehäuses aufweist, und die Anordnung sich weiterhin dadurch auszeichnet, dass ein Kontaktierungselement eines elektronischen Bauteils der Elektronik in der Weise zwischen der Öffnung und dem Schaltungsträger angeordnet ist, dass die Elektronik von durch die Öffnung in das Gehäuse eindringender Störstrahlung zumindest teilweise abgeschirmt wird. Mit anderen Worten ist durch die Öffnung in das Gehäuse eindringende Störstrahlung mittels des Kontaktierungselements ableitbar. In vorteilhafter Weise kann somit eine Positionierung beispielsweise einer Druckausgleichsöffnung im Bereich ESD-sensibler Elektronik realisiert werden. Die Begriffe Elektrik und Elektronik bzw. daran angelehnte Ausdrücke werden im Rahmen dieser Beschreibung synonym verwendet. Ein elektronisches Bauteil kann dabei ein diskretes Bauelement oder eine Baugruppe sein, welche einer gemeinsamen Funktion zugrundliegen können, jedoch nicht notwendigerweise müssen. Als das Innere des Gehäuses wird der die Elektronik einfassende Raum verstanden.

Gemäß einer bevorzugten Ausführungsform der Erfindung ist das elektronische Bauteil mittels des Kontaktierungselements mit dem Schaltungsträger elektrisch leitend verbunden, wobei das elektronische Bauteil ein funktioneller Bestandteil eines Laststromkreises zur Ansteuerung eines Verbrauchers ist. Somit wird eine vorteilhafte Ausnutzung wenigstens eines ohnehin vorhandenen elektronischen Bauteils für die Abschirmung ESD-empfindlicher Elektronik gegenüber Störstrahlung verwendet. Bevorzugt ist der Verbraucher ein Elektromotor, insbesondere Pumpenmotor eines Bremsensteuergeräts eines Fahrzeugs.

Zweckmäßigerweise ist das elektronische Bauteil ein Entstörbauteil. Entstörbauteile sind für die Filterung z.B. von hochfrequenten Wechselstromanteilen ausgelegt, weshalb es sich nicht um ESD-empfindliche Bauteile handelt und diese Bauteile daher besonders vorteilhaft für die Abschirmfunktion im Sinne der Erfindung einsetzbar sind.

Die Formgebung des Kontaktierungselements und/oder eine relative Anordnung des Kontaktierungselements zu der Öffnung sind entsprechend einer vorteilhaften Weiterbildung der Erfindung derart, dass unter Berücksichtigung einer Ausgestaltung der Öffnung und/oder eines vorhandenen Bauraumes im Inneren des Gehäuses eine möglichst geringe Störeinstrahlung auf den Schaltungsträger vorliegt.

Bevorzugt weist das Gehäuse eine die Öffnung zumindest teilweise einfassende Ausformung zur Abschirmung von Störstrahlung auf. Dadurch wird eine ergänzende Abschirmung der Elektronik bzw. der auf dem Schaltungsträger angeordneten elektronischen Bauelemente im Bereich der Öffnung erzielt. Die Ausformung ist vorzugsweise im Inneren des Gehäuses angeordnet.

Bevorzugt umgibt die Ausformung die Öffnung zumindest teilweise kreisförmig. Dies ist insbesondere vorteilhaft, wenn die Öffnung ebenfalls kreisförmig ist.

Gemäß einer vorteilhaften Ausführungsform weist die Ausformung einen geöffneten Bereich zur Durchführung des Kontaktierungselements auf. Ein Vorteil davon ist, dass ein platzsparender Aufbau ermöglicht wird, da das Kontaktierungselement nicht über die Ausformung hinweg geführt werden muss.

Weitere bevorzugte Ausführungsformen ergeben sich aus der nachfolgenden Beschreibung eines Ausführungsbeispiels an Hand von Figuren.

In schematischer Darstellung zeigen:
- Fig. 1: ein Ausführungsbeispiel der erfindungsgemäßen Anordnung am Beispiel eines Druckausgleichsöffnung 1-4 und einer Drosselspule 1-2,
- Fig. 2: eine beispielhafte Kontaktierung der Drosselspule 1-2 an Schaltungsträger 2-1,
- Fig. 3: einen Ausschnitt eines Ausführungsbeispiels eines inneren Teils von Gehäuse 1-1 im Bereich von Druckausgleichsöffnung 1-4 und
- Fig. 4: einen Ausschnitt eines Ausführungsbeispiels eines äußeren Teils von Gehäuse 1-1 im Bereich von Druckausgleichsöffnung 1-4.

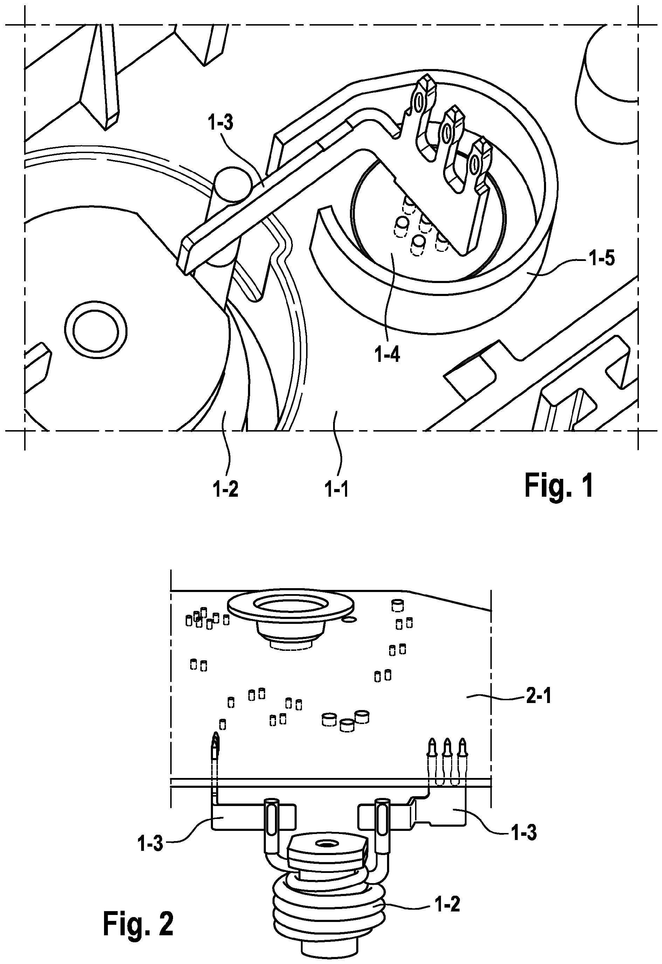

In Fig. 1 zeigt einen Ausschnitt eines Gehäuses 1-1 einer elektronischen Kontrolleinheit (ECU) eines elektrohydraulischen Bremsensteuergeräts, in welchem Druckausgleichsöffnung 1-4 vorgesehen ist, mittels welchem beispielsweise Druckschwankungen in Folge unterschiedlicher Temperaturen innerhalb und außerhalb von Gehäuse 1-1 sowie Kondensationsfeuchtigkeit vermieden werden können. Das elektrohydraulische Bremsensteuergerät bzw. das zugeordnete Gehäuse 1-1 ist durch entsprechende Abdichtung zumindest gegenüber dem Eindringen von Flüssigkeit geschützt. Zur Verhinderung des Eindringens von Flüssigkeit durch Öffnungen der Druckausgleichsöffnung 1-4 hindurch, umfasst Druckausgleichsöffnung 1-4 vorzugsweise eine für diesen Zweck geeignete Membran (nicht dargestellt). Beispielsgemäß ist zudem Drosselspule 1-2 abgebildet, welche über die Spulendrähte mittels Kontaktierungselementen 1-3 mit einem Schaltungsträger 2-1 elektrisch kontaktiert und zudem mechanisch gehalten werden, wie in Fig. 2 gezeigt, wobei in Fig. 2 zur besseren Veranschaulichung auf die Darstellung von Gehäuse 1-1 verzichtet wurde. Die Ausgestaltung der elektrischen und/oder mechanischen Verbindung mittels Kontaktierungselementen 1-3 ist dabei lediglich als beispielhaft zu verstehen.

Schaltungsträger 2-1 ist der Druckausgleichsöffnung 1-4 gegenüberliegend angeordnet, wodurch einerseits eine hohe Raumausnutzung vorliegt, jedoch die Elektronik, insbesondere im Bereich der Druckausgleichsöffnung 1-4, gegenüber Störeinstrahlung besonders anfällig ist. Um Einflüsse auf die Elektronik bzw. Schaltungsträger 2-4 in Folge von Störeinstrahlung zu vermeiden, ist wenigstens ein Kontaktierungselement 1-3 von Drosselspule 1-2 in der Weise zwischen Druckausgleichsöffnung 1-4 und Schaltungsträger 2-1 angeordnet, dass Störeinstrahlung wirksam ableitbar ist. Dadurch kann Druckausgleichsöffnung 1-4 auch in einem Bereich ESD sensibler Elektronik vorgesehen werden. Alternativ könnten die Spulendrähte bei entsprechender Formgebung auch unmittelbar als Abschirmung Verwendung finden. In vergleichbarer Weise können auch mehrere Kontaktierungselemente eines oder mehrerer elektronischer Bauteile zur Abschirmung von Störstrahlung im Bereich von Druckausgleichsöffnung 1-4 angeordnet sein.

Beispielsgemäß ist Kontaktierungselement 1-3 mit geringem Abstand zu Druckausgleichsöffnung 1-4 und etwa mittig davon angeordnet. Die relative Anordnung von Kontaktierungselement 1-3 zu Druckausgleichsöffnung 1-4 und/oder die Formgebung von Kontaktierungselement 1-3 kann unter Berücksichtigung der Positionierung von Schaltungsträger 2-1 insbesondere in Abhängigkeit der Ausgestaltung von Druckausgleichsöffnung 1-4, des vorhandenen Bauraumes und/oder bzgl. der Optimierung hinsichtlich der Verringerung der Störeinstrahlung von dem in Fig. 1 gezeigten Ausführungsbeispiel abweichen. Die Verwendung von Kontaktierungselement 1-3 eines Entstörbauteils, wie Drosselspule 1-2, ist für die Realisierung des Schutzes vor Störeinstrahlung besonders vorteilhaft, da diese entsprechend der gezeigten Ausführungsform ohnehin als Drossel zur Filterung hochfrequenter Wechselstromanteile eines Leistungsstromkreises für Verbraucher des elektrohydraulischen Bremsensteuergeräts vorgesehen ist. Ein solcher Verbraucher ist beispielsweise ein Elektromotor zum Betreiben einer hydraulischen Pumpe des Bremsensteuergeräts, durch die der Druck in den Bremskreisen realisierbar ist.

Kontaktierungselement 1-3 kann - ohne Einschränkung der Druckausgleichsfunktionalität - beispielsweise auch in der Weise ausgelegt sein, dass Druckausgleichsöffnung 1-4 teilweise oder vollständig flächig überdeckt ist.

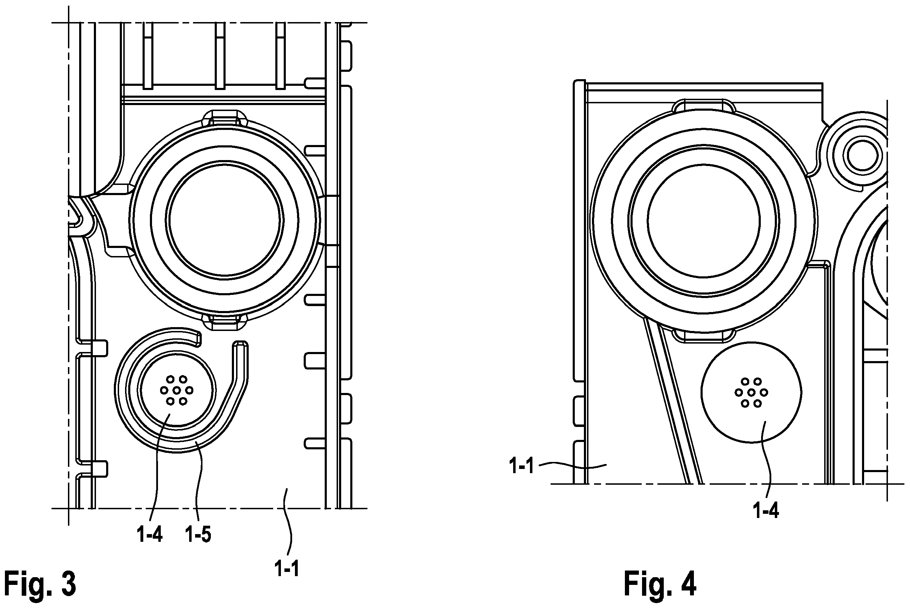

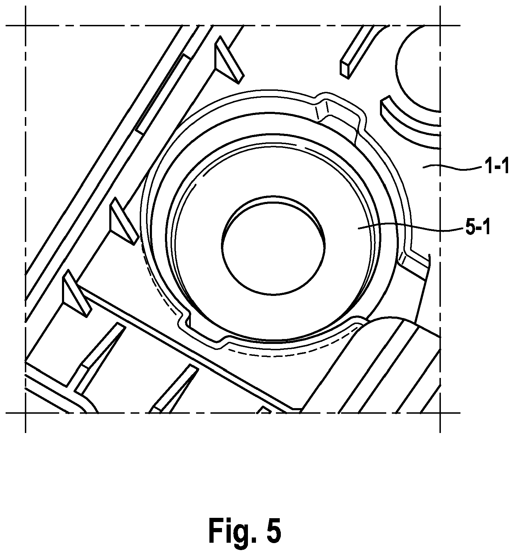

Um die aufgrund der Druckausgleichsöffnung 1-4 gegenüber Störstrahlung potentiell exponierbare Fläche von Schaltungsträger 2-1 zu begrenzen und damit die Abschirmung durch Kontaktierungselement 1-3 wirksamer zu gestalten, weist Gehäuse 1-1 eine die Druckausgleichsöffnung 1-4 zumindest teilweise einfassende Ausformung 1-5 im Inneren des Gehäuses 1-1 auf. Beispielsgemäß beschreibt diese eine Kontur, welche die Druckausgleichsöffnung 1-4 teilweise kreisförmig umgibt, jedoch einen geöffneten Bereich für die Durchführung von Kontaktierungselement 1-3 aufweist. Fig. 3 zeigt zur Veranschaulichung einen Ausschnitt im Bereich von Druckausgleichsöffnung 1-4 eines inneren Teils - in welchem die Elektronik angeordnet ist - von Gehäuse 1-1, entsprechend des Ausführungsbeispiels der Fig. 1. Fig. 4 zeigt entsprechend einen Ausschnitt eines äußeren Teils desselben Gehäuses 1-1 im Bereich von Druckausgleichsöffnung 1-4.

## Patentansprüche

1. Anordnung zum Schutz von Elektronik gegenüber Störstrahlung, umfassend ein Gehäuse (1-1) und einen Schaltungsträger (2-1) zum Aufnehmen der Elektronik in einem Inneren des Gehäuses (1-1), wobei das Gehäuse (1-1) eine Öffnung (1-4) zum Ausgleich unterschiedlicher Drücke innerhalb und außerhalb des Gehäuses (1-1) aufweist, **dadurch gekennzeichnet, dass** ein Kontaktierungselement (1-3) eines elektronischen Bauteils (1-2) der Elektronik in der Weise zwischen der Öffnung (1-4) und dem Schaltungsträger (2-1) angeordnet ist, dass die Elektronik von durch die Öffnung (1-4) in das Gehäuse (1-1) eindringender Störstrahlung zumindest teilweise abgeschirmt wird, wobei durch die Öffnung in das Gehäuse (1-1) eindringende Störstrahlung mittels des Kontaktierungselements (1-3) ableitbar ist.

2. Anordnung gemäß Anspruch 1, **dadurch gekennzeichnet, dass** das elektronische Bauteil (1-2) mittels des Kontaktierungselements (1-3) mit dem Schaltungsträger (2-1) elektrisch leitend verbunden ist, wobei das elektronische Bauteil (1-2) ein funktioneller Bestandteil eines Laststromkreises zur Ansteuerung eines Verbrauchers ist.

3. Anordnung gemäß Anspruch 1 oder 2, **dadurch gekennzeichnet, dass** das elektronische Bauteil (1-2) ein Entstörbauteil ist.

4. Anordnung gemäß Anspruch 1 bis 3, **dadurch gekennzeichnet, dass** die Formgebung des Kontaktierungselements (1-3) und/oder eine relative Anordnung des Kontaktierungselements (1-3) zu der Öffnung (1-4) derart ist, dass unter Berücksichtigung einer Ausgestaltung der Öffnung (1-4) und/oder eines vorhandenen Bauraumes im Inneren des Gehäuses (1-1) eine möglichst geringe Störeinstrahlung auf den Schaltungsträger (2-1) vorliegt.

5. Anordnung gemäß einem der vorhergehenden Ansprüche, **dadurch gekennzeichnet, dass** das Gehäuse (1-1) eine die Öffnung (1-4) zumindest teilweise einfassende Ausformung (1-5) zur Abschirmung von Störstrahlung aufweist.

6. Anordnung gemäß Anspruch 5, **dadurch gekennzeichnet, dass** die Ausformung (1-5) im Inneren des Gehäuses (1-1) angeordnet ist.

7. Anordnung gemäß einem der Ansprüche 5 oder 6, **dadurch gekennzeichnet, dass** die Ausformung (1-5) einen geöffneten Bereich zur Durchführung des Kontaktierungselements (1-3) aufweist.

## Claims

1. Arrangement for protecting electronics from interference radiation, comprising a housing (1-1) and a circuit carrier (2-1) for accommodating the electronics in an interior of the housing (1-1), wherein the housing (1-1) has an opening (1-4) for the compensation of different pressures inside and outside the housing (1-1), **characterized in that** a contact-making element (1-3) of an electronic component (1-2) of the electronics is arranged between the opening (1-4) and the circuit carrier (2-1), in such a manner that the electronics are at least partially screened from interference radiation entering the housing (1-1) through the opening (1-4), wherein interference radiation entering the housing (1-1) through the opening can be diverted by means of the contact-making element (1-3).

2. Arrangement according to Claim 1, **characterized in that** the electronic component (1-2) is connected to the circuit carrier (2-1) in an electrically-conductive manner by means of the contact-making element (1-3), wherein the electronic component (1-2) is a functional constituent of a load current circuit for the control of a load.

3. Arrangement according to Claim 1 or 2, **characterized in that** the electronic component (1-2) is an interference-suppression component.

4. Arrangement according to Claims 1 to 3, **characterized in that** the design of the contact-making element (1-3) and/or an arrangement of the contact-making element (1-3) relative to the opening (1-4) are such that, in consideration of a configuration of the opening (1-4) and/or of an available installation space in the interior of the housing (1-1), a lowest possible level of interference radiation is present on the circuit carrier (2-1) .

5. Arrangement according to one of the preceding claims, **characterized in that** the housing (1-1) incorporates a molding (1-5) which at least partially encloses the opening (1-4), for the screening of interference radiation.

6. Arrangement according to Claim 5, **characterized in that** the molding (1-5) is arranged in the interior of the housing (1-1).

7. Arrangement according to one of Claims 5 or 6, **characterized in that** the molding (1-5) incorporates an open region for the feedthrough of the contact-making element (1-3).

## Revendications

1. Arrangement de protection d'une électronique contre un rayonnement parasite, comprenant un boîtier (1-1) et un porte-circuit (2-1) destiné à accueillir l'électronique dans un intérieur du boîtier (1-1), le boîtier (1-1) possédant une ouverture (1-4) destinée à équilibrer les différentes pressions à l'intérieur et à l'extérieur du boîtier (1-1), **caractérisé en ce qu'**un élément de mise en contact (1-3) d'un composant électronique (1-2) de l'électronique est disposé entre l'ouverture (1-4) et le porte-circuit (2-1) de telle sorte que l'électronique est protégée par blindage au moins partiellement du rayonnement parasite qui pénètre dans le boîtier (1-1) à travers l'ouverture (1-4), le rayonnement parasite qui pénètre dans le boîtier (1-1) à travers l'ouverture pouvant être dérivé au moyen de l'élément de mise en contact (1-3).

2. Arrangement selon la revendication 1, **caractérisé en ce que** le composant électronique (1-2) est relié de manière électriquement conductrice au porte-circuit (2-1) par le biais de l'élément de mise en contact (1-3), le composant électronique (1-2) étant un élément constitutif fonctionnel d'un circuit de courant de charge destiné à commander un récepteur.

3. Arrangement selon la revendication 1 ou 2, **caractérisé en ce que** le composant électronique (1-2) est un composant d'antiparasitage.

4. Arrangement selon les revendications 1 à 3, **caractérisé en ce que** la conformation de l'élément de mise en contact (1-3) et/ou un arrangement relatif de l'élément de mise en contact (1-3) par rapport à l'ouverture (1-4) est tel qu'en considération d'une configuration de l'ouverture (1-4) et/ou d'un espace de montage présent à l'intérieur du boîtier (1-1), un rayonnement parasite aussi faible que possible est présent sur le porte-circuit (2-1).

5. Arrangement selon l'une des revendications précédentes, **caractérisé en ce que** le boîtier (1-1) présente un façonnage (1-5) qui entoure au moins partiellement l'ouverture (1-4) et servant à la protection par blindage contre le rayonnement parasite.

6. Arrangement selon la revendication 5, **caractérisé en ce que** le façonnage (1-5) est disposé à l'intérieur du boîtier (1-1).

7. Arrangement selon la revendication 5 ou 6, **caractérisé en ce que** le façonnage (1-5) possède une zone ouverte servant au passage de l'élément de mise en contact (1-3).
